# EUROPÄISCHE PATENTANMELDUNG

(11) **EP 4 407 503 A1**
(43) Veröffentlichungstag der Anmeldung: **31.07.2024**
(21) Anmeldenummer: 23153648.3
(22) Anmeldetag: 27.01.2023
(51) Int. Cl.: G06F 30/13

(54) **COMPUTERIMPLEMENTIERTES VERFAHREN ZUM ENTWERFEN EINER OBERFLÄCHENKONSTRUKTION UND VERFAHREN ZUR HERSTELLUNG EINER OBERFLÄCHENKONSTRUKTION**

(71) Anmelder: Climagrün GmbH, 39100 Bozen (IT)
(72) Erfinder: KORNPROBST, Klaus, 39100 Bozen (IT); TROJER, Thomas, 39058 Sarntal (IT)
(74) Vertreter: Torggler & Hofmann Patentanwälte - Innsbruck

(57) **Zusammenfassung**

Computerimplementiertes Verfahren zum Entwerfen einer Oberflächenkonstruktion, insbesondere einer bepflanzten Oberflächenkonstruktion, welche auf zumindest einem Bereich eines Bauwerks, insbesondere eines Dachs, aufgebaut wird, mit den folgenden Verfahrensschritten:
- Eingabe mindestens eines Bauwerksparameters (I1) des zumindest eines Bereichs des Bauwerks, insbesondere einer Fläche und/oder einer Neigung und/oder eine Angabe zur Art des Bauwerks und/oder eines Orts des Bauwerks, und/oder
- Eingabe mindestens eines Konstruktionsparameters (I2) der Oberflächenkonstruktion, insbesondere einer Vegetation und/oder einer Kiesfläche und/oder eines Geh- und/oder Fahrbelags und/oder einer Substratschicht und/oder einer Tragschicht und/oder von Systemkomponenten, beispielsweise eines Schutzelements, eines Drainage-, Drainage-Wasserspeicher- und/oder Retentionselements und/oder eines Filterelements, und/oder von Zubehörkomponenten,
- optional Eingabe und/oder Abruf und/oder Berechnung wenigstens eines Sollwerts und/oder eines Grenzwerts mindestens eines Konstruktionsparameters der Oberflächenkonstruktion,
- Berechnung eines Datensatzes (O) der Oberflächenkonstruktion auf Basis des mindestens einen Bauwerksparameters und/oder des mindestens einen Konstruktionsparameters, insbesondere wobei der Datensatz (O) ein Gewicht pro Flächeneinheit und/oder bezogen auf den zumindest einen Bereich, eine Aufbauhöhe, ein Volumen und/oder eine Anstauhöhe eines temporären und/oder permanenten Retentionsspeichers, eine Abflussspende und/oder einen Spitzenablussbeiwert umfasst,
- optional Vergleich wenigstens eines Sollwerts und/oder Grenzwerts mit einem berechneten Wert des Datensatzes der Oberflächenkonstruktion, vorzugsweise Ausgabe einer Warnmeldung (W) bei der Feststellung einer Diskrepanz zum wenigstens einen Sollwert und/oder einer Über- oder Unterschreitung des wenigstens einen Grenzwerts.

## Beschreibung

Die Erfindung betrifft ein computerimplementiertes Verfahren zum Entwerfen einer Oberflächenkonstruktion, insbesondere einer bepflanzten Oberflächenkonstruktion, welche auf zumindest einem Bereich eines Bauwerks aufgebaut wird. Des Weiteren betrifft die Erfindung eine Vorrichtung zur Datenverarbeitung, ein computerlesbares Speichermedium, ein Computerprogrammprodukt, einen computerlesbaren Datenträger und ein Datenträgersignal.

Die Erfindung betrifft des Weiteren ein Verfahren zur Herstellung einer Oberflächenkonstruktion, insbesondere einer bepflanzten Oberflächenkonstruktion, welche mittels eines computerimplementierten Verfahrens entworfen wurde.

Eingangs genannte Oberflächenkonstruktionen, welche auf zumindest einem Bereich eines Bauwerks, insbesondere eines Dachs, aufgebaut werden, sind bereits in einer Vielzahl von Ausführungen bekannt.

Beispielsweise kann die Oberflächenkonstruktion eine Konstruktion zur Begrünung sein, wobei die Oberflächenkonstruktion vorzugsweise auf einem Dach aufgebaut wird. Eine Oberflächenkonstruktion kann auch eine Konstruktion für eine Kiesfläche oder für Geh- oder Fahrbeläge sein.

Typischerweise umfasst eine Oberflächenkonstruktion mehrere Schichten. Eine Schicht kann eine Systemschicht sein, welche beispielsweise zur Drainage oder Speicherung von Wasser und/oder zum Schutz vor mechanischer Belastung und Pflanzenwurzeln und/oder zur Filterung vorgesehen ist. Eine weitere Schicht kann eine Substratschicht zum Tragen und Nähren von Pflanzen, welche eine Vegetationsschicht bilden, sein. Alternativ kann eine Tragschicht für einen Geh- oder Fahrweg vorgesehen sein. Auch kann eine Kiesschicht ohne Auflage vorgesehen sein.

Ein Beispiel einer Oberflächenkonstruktion mit Wasserrückhaltung ist in der Druckschrift WO 2022/049224 A1 beschrieben. Die Schrift betrifft ein System zur Rückhaltung für Dächer, wobei eine erste Schicht durch einen undurchlässigen Schutz gebildet wird, der gegen Pflanzenwurzeln, Vegetation und dergleichen beständig ist, wobei auf der ersten Schicht eine zweite Schutzschicht angeordnet ist. Auf den zwei besagten Schichten ist eine Struktur angeordnet, die aus einer Reihe von miteinander verbundenen Elementen gebildet ist, die eine Stützstruktur bilden. Die Stützstruktur bildet eine Rückhaltekammer aus. Über der Stützstruktur ist ein durchlässiges Filtervlies angeordnet, das Wasser tropfenweise in die Rückhaltekammer lässt. Auf dem Filtervlies ist ein Substrat mit einem für die Vegetation geeigneten Material angeordnet oder ein Substrat aus einem inerten Material, wie Kies, angeordnet. Zudem kann ein Bewässerungssystem vorgesehen sein, das Wasser aus der Rückhaltekammer oder einem angrenzenden Bereich zur Vegetation pumpen kann.

Oberflächenkonstruktionen der eingangs erwähnten Art weisen eine Vielzahl von Konstruktionskomponenten auf, wodurch das Entwerfen und die Herstellung einer funktionstüchtigen Oberflächenkonstruktion eine komplexe Aufgabe ist. Insbesondere müssen die Konstruktionskomponenten an die jeweiligen Gegebenheiten des Bauwerks, insbesondere des Daches, angepasst werden und untereinander kompatibel sein.

So darf beispielsweise eine maximale Dachlast nicht überschritten werden. Zudem kann beispielsweise eine Speicherkapazität für Wasser gewünscht sein, mittels welchem eine Vegetation gewässert werden kann bzw. welche die Abflussspende vom Dach verkleinert und für eine Wasserretention sorgt.

Eine Vielzahl von weiteren Bedingungen müssen oder sollen erfüllt werden, um eine funktionstüchtige Oberflächenkonstruktion zu entwerfen. Die Bedingungen sind dabei von Fall zu Fall unterschiedlich und können insbesondere von dem Bauwerk, den klimatischen Bedingungen, den Wünschen eines Architekten oder Bauträgers, Normen und/oder Richtlinien usw. abhängen.

Bekannt sind Konfiguratoren, welche das Entwerfen einer Oberflächenkonstruktion vereinfachen. Durch die Wahl der Art des Bauwerks, insbesondere zum Dach, und weiteren Abfragen wird bei einem bekannten Konfigurator eine Empfehlung eines Gesamtsystems der Oberflächenkonstruktion als Output angegeben.

Nachteilig am bekannten Stand der Technik ist unter anderem, dass nur eine Empfehlung eines Gesamtsystems ausgegeben wird. Es ist nicht möglich, Parameter der Oberflächenkonstruktion automatisch oder manuell zu überprüfen, und somit die Oberflächenkonstruktion gegebenenfalls anzupassen. Beispielsweise ist es nicht möglich, zu überprüfen, ob die maximale Dachlast eingehalten wird, ob eine Aufbauhöhe des Systems den bestimmten Vorgaben entsprechen oder ob eine gewisser Mindestspeicher für Wasser realisiert ist.

Die Aufgabe der Erfindung ist, ein computerimplementiertes Verfahren zum Entwerfen einer Oberflächenkonstruktion und ein Verfahren zur Herstellung einer Oberflächenkonstruktion zu schaffen, mittels welchem Parameter der Oberflächenkonstruktion manuell oder automatisch überprüft werden können, bevor die Oberflächenkonstruktion hergestellt wird bzw. am Bauwerk aufgebaut wird.

Die Aufgabe wird gelöst durch das computerimplementierte Verfahren aus Anspruch 1, die Vorrichtung zur Datenverarbeitung aus Anspruch 9, das computerlesbare Speichermedium aus Anspruch 10, das Computerprogrammprodukt aus Anspruch 11, den computerlesbaren Datenträger aus Anspruch 12, das Datenträgersignal aus Anspruch 13 und das Verfahren zur Herstellung einer Oberflächenkonstruktion aus Anspruch 14.

Im Sinn der vorliegenden Schrift kann ein Bauwerk ein beliebiges Bauwerk wie ein Haus, eine Tiefgarage, ein Platz, usw. sein.

Der Bereich des Bauwerks, auf den eine Oberflächenkonstruktion aufgebaut wird ist vorzugsweise nicht geneigt, oder zumindest nur leicht geneigt, insbesondere weniger als 5°. Es handelt bevorzugt um ein Dach des Bauwerks.

Das erfindungsgemäße computerimplementierte Verfahren zum Entwerfen einer Oberflächenkonstruktion, insbesondere einer bepflanzten Oberflächenkonstruktion, welche auf zumindest einem Bereich eines Bauwerks, insbesondere eines Dachs, aufgebaut wird, weist die folgenden Verfahrensschritte auf:
- Eingabe mindestens eines Bauwerksparameters des zumindest eines Bereichs des Bauwerks, insbesondere einer Fläche und/oder einer Neigung und/oder eine Angabe zur Art des Bauwerks und/oder eines Orts des Bauwerks, und/oder
- Eingabe mindestens eines Konstruktionsparameters der Oberflächenkonstruktion, insbesondere einer Vegetation und/oder einer Kiesfläche und/oder eines Geh- und/oder Fahrbelags und/oder einer Substratschicht und/oder einer Tragschicht und/oder von Systemkomponenten, beispielsweise eines Schutzelements, eines Drainage-, Drainage-Wasserspeicher- und/oder Retentionselements, und/oder von Zubehörkomponenten,
- Berechnung eines Datensatzes der Oberflächenkonstruktion auf Basis des mindestens einen Bauwerksparameters und/oder des mindestens einen Konstruktionsparameters, insbesondere wobei der Datensatz ein Gewicht pro Flächeneinheit und/oder bezogen auf den zumindest einen Bereich, eine Aufbauhöhe, ein Volumen und/oder eine Anstauhöhe eines temporären und/oder permanenten Retentionsspeichers, eine Abflussspende und/oder einen Spitzenablussbeiwert umfasst.

Dadurch, dass ein Datensatz der Oberflächenkonstruktion auf Basis des mindestens einen Bauwerksparameters und/oder des mindestens einen Konstruktionsparameters berechnet wird, kann die Oberflächenkonstruktion manuell oder automatisch überprüft werden, bevor die Oberflächenkonstruktion hergestellt wird oder am Bauwerk aufgebaut wird.

Nach der Überprüfung des Entwurfs, können die Konstruktionsparameter angepasst werden, sodass gewünschte oder technisch notwendige Bedingungen erfüllt sind.

Beispielweise kann der Datensatz ein Gewicht pro Flächeneinheit und/oder bezogen auf den zumindest einen Bereich umfassen. Das erhaltene Gewicht kann mit einem maximal zulässigen Gewicht des Bauwerks verglichen werden. Die Konstruktionsparameter der Oberflächenkonstruktion können angepasst werden, sodass das Gewicht unter dem maximal zulässigen Gewicht des Bauwerks liegt.

Beispielsweise kann der Datensatz eine Aufbauhöhe der Oberflächenkonstruktion umfassen. Die Aufbauhöhe kann mit einer, beispielsweise bauwerks- oder normenbedingten, maximalen Aufbauhöhe verglichen werden. Die Parameter der Oberflächenkonstruktion können angepasst werden, sodass die Aufbauhöhe unter der maximal zulässigen Aufbauhöhe für das Bauwerk liegt.

Beispielsweise kann der Datensatz ein Volumen und/oder eine Anstauhöhe eines temporären und/oder permanenten Retentionsspeichers umfassen.

Der permanente Retentionsspeicher kann zur Bewässerung einer gegebenenfalls vorhandenen Vegetation benützt werden. Das Volumen oder die Anstauhöhe eines permanenten Retentionsspeichers kann, beispielsweise durch die Wahl größerer Retentionselemente zur Beabstandung von Substrat und/oder Kies von der Bauwerkoberfläche, an die jeweiligen klimatischen Bedingungen angepasst werden. Bei einer großzügigen Auslegung des permanenten Retentionsspeichers kann die Zufuhr von Leitungswasser verringert werden, womit Wasser gespart wird.

Der temporäre Retentionsspeicher beinhaltet die Menge an Wasser, die im Falle von starkem Niederschlag über den permanenten Retentionsspeicher hinaus temporär zurückgehalten werden kann. Wasser aus dem temporären Retentionsspeicher fließt typischerweise langsam ab. Damit kann Wasser langsamer an die Kanalisation abgegeben werden, womit eine Überlastung der Kanalisation verhindert wird.

Die Größe des permanenten und temporären Retentionsspeichers kann unter anderem durch die Dimensionierung eines Anstauelements bzw. einer Drossel bestimmt werden. Die Größe eines Retentionselements kann ebenfalls beachtet werden. Bei der Dimensionierung muss auf das maximal zulässige Gewicht für die Oberflächenkonstruktion geachtet werden.

Beispielsweise kann der Datensatz eine Abflussspende umfassen. Die Abflussspende ist der Abfluss (Volumen pro Zeit) dividiert durch die Einzugsfläche. Bei nur einem Wasserablauf entspricht die Einzugsfläche der Fläche des Bereichs der Oberflächenkonstruktion. Die Abflussspende hängt von der Größe und Anzahl der Wasserabläufe und von eines gegebenenfalls vorhandenen Anstauelements mit oder ohne Drossel ab.

Beispielsweise kann der Datensatz einen Spitzenablussbeiwert umfassen. Der Spitzenabflussbeiwert ist das Verhältnis desjenigen Teils eines Niederschlagsereignisses, der direkt zum Abfluss gelangt, zum Gesamtniederschlag.

Die Angabe der Elemente des Datensatzes sind bevorzugte Ausführungsbeispiele. Weitere Ausführungsbeispiele sind denkbar.

Der berechnete Datensatz kann von Bauwerksparametern des zumindest einen Bereichs des Bauwerks und/oder Konstruktionsparametern der Oberflächenkonstruktion abhängen.

Ein Bauwerksparameter kann insbesondere eine Fläche des Bereichs sein, auf welchen die Oberflächenkonstruktion aufgebaut werden soll. Ein Bauwerksparameter kann die Neigung des Bauwerks in dem Bereich sein. Ein Bauwerksparameter kann eine Angabe zur Art des Bauwerks sein. Beispielsweise kann angegeben werden, ob es sich um ein Kalt-/Warmdach oder um ein Umkehrdach handelt. Als Bauwerksparameter kann auch der Ort des Bauwerks angegeben werden. Der Ort kann Auswirkungen auf die klimatischen Bedingungen oder auf gültige Normen haben.

Ein Konstruktionsparameter kann ein Parameter einer Vegetation und/oder einer Kiesfläche und/oder eines Geh- und/oder Fahrbelags und/oder einer Substratschicht und/oder einer Tragschicht und/oder Systemkomponenten, beispielsweise eines Schutzelements, eines Drainage-, Drainage-Wasserspeicher- und/oder eines Retentionselements und/oder eines Filterelements und/oder von Zubehörkomponenten sein. Die angegebenen Beispiele sind nicht erschöpfend, es sind weitere Ausführungsformen denkbar.

Es kann beispielsweise vorgesehen sein, dass ein Element die Funktionen eines Drainage-, Drainage-Wasserspeicher- und Retentionselements und eines Schutzelements und eines Filterelements zugleich erfüllt.

Konstruktionsparameter können bevorzugt für einzelne Konstruktionskomponenten eingegeben werden.

Ein Konstruktionsparameter kann eine Höhe einer Konstruktionskomponente sein. Insbesondere im Fall der Höhe eines Substrats kann die Höhe eines verdichteten Substrats angegeben werden.

Ein Konstruktionsparameter kann ein Gewicht einer Konstruktionskomponente sein. Insbesondere kann ein Gewicht inklusive einer maximalen Wasserkapazität der Konstruktionskomponente angegeben werden.

Eine Konstruktionsparameter kann eine permanente oder temporäre Anstauhöhe sein. Die Anstauhöhe kann beispielsweise innerhalb durch die Höhe mindestens einer Konstruktionskomponente bestimmter Grenzen gewählt werden. Beispielsweise kann die Grenze einer permanenten oder temporären Anstauhöhe von einer Höhe eines Anstauelements und/oder eine Höhe eines Retentionselements abhängen und einen gewissen Mindestwert aufweisen.

Die eingegebenen Konstruktionsparameter entsprechen, wenn nicht anderweitig angegeben, Istwerten der entworfenen Oberflächenkonstruktion.

In einem bevorzugten Ausführungsbeispiel können zudem Sollwerte und/oder Grenzwerte eines Konstruktionsparameters der Oberflächenkonstruktion eingegeben werden.

Optional sind die folgenden Schritte vorgesehen:
- Eingabe und/oder Abruf und/oder Berechnung wenigstens eines Sollwerts und/oder eines Grenzwerts eines Konstruktionsparameters der Oberflächenkonstruktion,
- Vergleich wenigstens eines Sollwerts und/oder Grenzwerts mit einem berechneten Wert des Datensatzes der Oberflächenkonstruktion, vorzugsweise Ausgabe einer Warnmeldung bei der Feststellung einer Diskrepanz zum wenigstens einen Sollwert und/oder einer Über- oder Unterschreitung des wenigstens einen Grenzwerts.

Eine Überprüfung kann in diesem Ausführungsbeispiel im Zuge des computerimplementierten Verfahrens automatisch erfolgen. Beispielsweise kann, wenn ein maximales Gewicht pro Fläche eingegeben wurde, automatisch überprüft werden, ob das maximal zulässige Gewicht pro Fläche überschritten wurde. In so einem Fall kann vorzugsweise eine Warnmeldung ausgegeben werden.

Nachdem eine Warnmeldung ausgegeben wurde, kann der Bediener Parameter, insbesondere Konstruktionsparameter, abändern, sodass der Sollwert erreicht wird und/oder ein Grenzwert nicht mehr überschritten wird.

Insbesondere kann ein Bediener das computerimplementierte Verfahren (bewusst) weiter bedienen, wenn ein Sollwert nicht erreicht wird und/oder ein Grenzwert überschritten wird.

Sollwerte und/oder Grenzwerte können manuell als Zahlenwert von einem Bediener eingegeben werden. Zusätzlich oder alternativ können Sollwerte und/oder Grenzwerte aus einer Tabelle mit hinterlegten Werten abgerufen und/oder berechnet werden.

Die hinterlegten Werte können auf der Basis von Erfahrungswerten und/oder Normen und/oder Richtlinien abgerufen und/oder berechnet werden.

Die hinterlegten Werte können bedingt durch die Eingabe eines bestimmten Bauwerksparameters abgerufen und/oder berechnet werden. Beispielsweise kann ein Ort des Bauwerks eine in der jeweiligen Region gültige Norm bedingen, aus welcher ein Sollwert und/oder Grenzwert abgerufen werden kann.

Die hinterlegten Werte können bedingt durch die Wahl einer Konstruktionskomponente abgerufen und/oder berechnet werden. Beispielsweise kann die Wahl einer bestimmten Vegetation, beispielsweise eines großen Baums, eine Mindesthöhe eines Substrats als Grenzwert bedingen.

"Eingabe" muss im Sinne der vorliegenden Anmeldung nicht die manuelle Eingabe eines Zahlenwerts bedeuten.

Insbesondere bei der Eingabe von Konstruktionsparametern ist bevorzugt vorgesehen, dass diese zumindest teilweise mittels der Auswahl mindestens einer Konstruktionskomponente mit mindestens einem vordefinierten Konstruktionsparameter aus mindestens einer Komponentenliste erfolgt.

Damit kann vom Bediener auf einfache Art und Weise eine Konstruktionskomponente ausgewählt werden. Die Eingabe der Konstruktionsparameter der Konstruktionskomponente erfolgt automatisch auf Basis der Auswahl einer der Konstruktionskomponenten. So kann beispielsweise für eine Konstruktionskomponente ein bestimmtes Gewicht (inklusive oder exklusive maximaler Wasserkapazität) und/oder eine bestimmte Aufbauhöhe hinterlegt sein, welche mittels einer Auswahl der Konstruktionskomponente eingegeben wird.

Für alle Systemlösungen gibt es bereits vordefinierte Auswahlen von Konstruktionskomponenten, um dem Benutzer die Eingabe zu erleichtern. Insbesondere können in den jeweiligen Komponentenlisten Konstruktionskomponenten vorausgewählt sein.

Es kann vorgesehen sein, dass bei der Wahl mindestens einer Konstruktionskomponente ein Konstruktionsparameter als Zahlenwert eingegeben werden kann. Insbesondere kann eine Aufbauhöhe einer Kies- oder Substratschicht als Zahlenwert eingegeben werden, da die Schichthöhe nicht fest definiert ist.

Es kann auch vorgesehen sein, dass mindestens ein Konstruktionsparameter vordefiniert ist und bei der Auswahl einer Konstruktionskomponente übernommen wird und dass mindestens ein weiterer Konstruktionsparameter manuell als Zahlenwert eingegeben wird.

Bevorzugt sind mindestens zwei verschiedene Komponentenlisten vorgesehen. Bevorzugt sind in den unterschiedlichen Listen Konstruktionskomponenten unterschiedlicher Schichten der Oberflächenkonstruktion enthalten.

Besonders bevorzugt weist eine erste Komponentenliste Einträge zu Konstruktionskomponenten einer ersten Schicht der Oberflächenkonstruktion, insbesondere Einträge zu einem Vegetationstyp und/oder zu einem Geh- und/oder Fahrbelagstyp, auf. Die erste Schicht entspricht der obersten Schicht der Oberflächenkonstruktion. Die erste Schicht ist nicht zwingend vorhanden, da auf eine Vegetation oder Geh- und/oder Fahrbeläge verzichtet werden kann, wie beispielsweise bei einem Kiesdach.

Ein Vegetationstyp können verschiedene extensive oder intensive Vegetationsformen sein. Beispielsweise für Vegetationstypen sind Knollen, Kräutermischung, Gräser/Kräuter, Kleinballenpflanzen, usw.

Ein Geh- und/oder Fahrbelag kann beispielsweise Asphalt, Pflaster oder Platten sein.

Auch Biodiversitätselemente wie Sandlinsen, Kiesflächen oder temporäre Wasserflächen können in der ersten Schicht vorgesehen sein.

Zusätzlich oder alternativ weist besonders bevorzugt eine zweite Komponentenliste Einträge zu Konstruktionskomponenten einer zweiten Schicht der Oberflächenkonstruktion, insbesondere Einträge zu einem Substrattyp und/oder zu einem Kiesschichttyp und/oder zu einem Tragschichttyp zur Lastenverteilung, auf.

Ein Substrattyp kann in leichter oder schwerer Ausführung auswählbar sein. Substrat ist als Nährboden für die Vegetation der ersten Schicht geeignet.

Ein Kiesschichttyp kann verschiedene Kiessorten und anderes Schüttgut enthalten. Eine Kiesschicht kann die oberste Schicht in einem Bereich darstellen.

Ein Tragschichttyp zur Lastenverteilung kann ungebunden oder gebunden sein. Eine ungebundene Tragschicht kann Blähton oder Schotter umfassen. Eine gebundene Tragschicht kann Estrich oder Beton umfassen. Die Tragschicht kann als Unterlage für einen Geh- oder Fahrbelag verwendet werden.

Insbesondere in der zweiten Schicht kann die Aufbauhöhe optional manuell eingegeben werden. Schüttgut wie Schotter, Kies, Substrat oder dergleichen hat eine variable Aufbauhöhe.

Zusätzlich oder alternativ weist besonders bevorzugt eine dritte Komponentenliste Einträge zu Konstruktionskomponenten einer dritten Schicht der Oberflächenkonstruktion, insbesondere Einträge zu einem Schutzelementtyp und/oder zu einem Drainage-, Drainage-Wasserspeicher- und/oder Retentionselementtyp und/oder zu einem Filterschichttyp, auf.

Ein Schutzelementtyp kann ein Schutzvlies umfassen, welches das Bauwerk, insbesondere eine Dachabdichtung, vor Abnützung durch die Oberflächenkonstruktion schützen kann.

Ein Retentionselementtyp kann beispielsweise ein Retentionselement zur Beabstandung der zweiten Schicht vom Bauwerk sein. Mittels eines Retentionselements kann ein Retentionsspeicher für Wasser geschaffen werden.

Ein Drainagetyp kann ein Drainageelement sein. Das Drainageelement kann als Kunststoffmatte mit kleinen Mulden ausgebildet sein. In den Mulden kann Wasser gespeichert werden, wenn die Mulden wasserdicht sind (Drainage-Wasserspeichertyp) .

Ein Drainagetyp kann Drainagematerial, welches beispielsweise als Schüttgut, insbesondere Blähton, Lavakies und/oder Glasschaumschotter, vorliegen kann, sein.

Ein Filterschichttyp kann beispielsweise ein Filtervlies sein, welches Substrat, Schotter oder Kies daran hindert, in den Retentionsspeicher oder direkt auf das Dränelement zu rieseln. Typischerweise ist der Filterschichttyp wasserdurchlässig.

Zusätzlich oder alternativ kann besonders bevorzugt eine vierte Komponentenliste Einträge zu Zubehörkomponenten, insbesondere einer Pumpe und/oder eines Anstauelements und/oder eines Pumpenschachts und/oder einer Bewässerungsvorrichtung und/oder Drossel und/oder Einfassungen und/oder Pflanzengefäße und/oder Solarunterkonstruktionen und/oder Schrägdachprodukte und/oder Belagunterkonstruktionen, vorgesehen sein.

Eine Zubehörkomponente wird in der vorliegenden Anmeldung als Spezialfall einer Konstruktionskomponente angesehen.

Eine Pumpe kann dazu verwendet werden, Wasser aus einem Wasserspeicher zu entnehmen, um es beispielsweise der Vegetation zuzuführen.

Ein Anstauelement kann dazu verwendet werden, einen permanenten Retentionsspeicher anzustauen. Außerdem kann eine Drossel vorgesehen sein, mittels welcher eine temporärer, langsam abfließender Retentionsspeicher erzeugt wird. Das Anstauelement ist um den Wasserablauf angeordnet.

Ein Pumpenschacht kann insbesondere um den Abfluss angeordnet sein, sodass auf die Pumpe und den Wasserablauf zugegriffen werden kann. Im Pumpenschacht kann das Anstauelement angeordnet sein.

Eine Bewässerungsvorrichtung kann zur Bewässerung der Vegetation vorgesehen sein und kann von Wasser der Pumpe oder aus der Leitung gespeist werden. Sie kann als Sprinkelanlage außerhalb der Vegetation oder als Unterflurbewässerung innerhalb des Substrats ausgebildet sein. Die Bewässerungsvorrichtung kann alternativ passiv ausgebildet sein und beispielsweise als Kapillarvlies, das Wasser aus einem Wasserspeicher saugt.

Einfassungen können beispielsweise Trennprofile zwischen zwei verschiedenartigen Bereichen der Oberflächenkonstruktion sein. Auch können Einfassungen für Hochbeete vorgesehen sein. Solarunterkonstruktionen können Befestigungsmittel für Solaranlagen sein. Schrägdachprodukte können zur Schubsicherung der Oberflächenkonstruktion vorgesehen sein. Belagunterkonstruktionen können zur Befestigung und/oder Auflage von Dielen und Platten dienen.

In einem bevorzugten Ausführungsbeispiel kann die Wahl mindestens eines Bauwerksparameters und/oder Konstruktionsparameters und/oder einer Norm und/oder einer Richtlinie und/oder Erfahrungswerten das Vorhandensein von Elementen mindestens einer Komponentenliste beeinflussen, insbesondere bestimmen. Normen und/oder Richtlinien und/oder Erfahrungswerte weisen vorzugsweise hinterlegte Werte auf, welche durch die Wahl eines Bauwerksparameters und/oder Konstruktionsparameters abgerufen werden können. Dadurch kann die angebotene Auswahl an Konstruktionskomponenten (Elemente der Komponentenlisten) an die jeweilige bereits bekannte Situation angepasst werden.

Es kann beispielsweise eine Vorauswahl getroffen werden, ob eine Oberflächenkonstruktion mit Wasserretention oder eine Oberflächenkonstruktion ohne Wasserretention vorgesehen ist. Beispielsweise kann dadurch die Auswahl an Konstruktionskomponenten in der Systemschicht beeinflusst werden. Zum Beispiel kann beeinflusst werden, ob ein Retentionselement angezeigt wird oder nicht.

Es kann auch eine Vorauswahl getroffen werden, ob eine Oberflächenkonstruktion mit Vegetation, Fahr- oder Gehbelag oder Kies als oberste Schicht geplant ist. Die kann die Konstruktionskomponenten insbesondere in der ersten Schicht beeinflussen. Zum Beispiel kann beeinflusst werden, ob entweder Vegetationstypen oder Fahr- und/oder Gehbeläge angezeigt werden.

Es kann durch die Wahl eines Bauwerksparameters, insbesondere ob ein Umkehrdach oder ein Kalt-/Warmdach vorliegt, beeinflusst werden, welche Komponenten ausgewählt werden können. Beispielsweise kann bei der Wahl eines Umkehrdachs eine für Umkehrdächer geeignete Trennlage angezeigt werden, welche sonst nicht angezeigt wird.

Es kann durch die Wahl des Orts eine Norm und/oder Richtlinien und/oder Erfahrungswerte bestimmt werden, womit bestimmte Komponenten angezeigt werden oder nicht. Beispielsweise können Konstruktionskomponenten, welche einer anwendbaren Norm nicht entsprechen, nicht angegeben werden.

In einem bevorzugten Ausführungsbeispiel werden mindestens zwei Komponentenlisten in mindestens zwei verschiedenen hierarchischen Ebenen organisiert und/oder angezeigt, wobei die Auswahl einer Konstruktionskomponente aus einer übergeordneten Komponentenliste das Vorhandensein von Elementen mindestens einer untergeordneten Komponentenliste beeinflusst, insbesondere bestimmt. Damit kann die Auswahl Komponenten an eine vorherige Auswahl unter Berücksichtigung der Kompatibilität verschiedener Konstruktionskomponenten angepasst werden.

Bevorzugt ist folgende hierarchische Reihenfolge von übergeordnet zu untergeordnet vorgesehen:
- erste Komponentenliste mit Einträgen zu einer ersten Schicht der Oberflächenkonstruktion, insbesondere Einträgen zu einem Vegetationstyp und/oder zu einem Geh- und/oder Fahrbelagstyp, sofern die erste Komponentenliste vorhanden ist,
- zweite Komponentenliste mit Einträgen zu einer zweiten Schicht der Oberflächenkonstruktion, insbesondere Einträgen zu einem Substrattyp und/oder zu einem Kiesschichttyp und/oder zu einem Tragschichttyp zur Lastenverteilung,
- dritte Komponentenliste mit Einträgen zu einer dritten Schicht der Oberflächenkonstruktion, insbesondere Einträgen zu einem Schutzelementtyp und/oder zu einem Drainage- und/oder Drainage-Wasserspeicher- und/oder Retentionselementtyp und/oder zu einem Filterschichttyp,
- vierte Komponentenliste mit Einträgen zu Zubehörkomponenten, insbesondere einer Pumpe und/oder eines Anstauelements und/oder eines Pumpenschachts und/oder einer Bewässerungsvorrichtung und/oder einer Drossel und/oder Einfassungen und/oder Pflanzengefäße und/oder Solarunterkonstruktionen und/oder Schrägdachprodukte und/oder Belagunterkonstruktionen.

Die Wahl von Konstruktionskomponenten der ersten Komponentenliste kann damit das Vorhandensein von Komponenten in der zweiten, dritten oder vierten Komponentenliste beeinflussen. Die Wahl von Konstruktionskomponenten der zweiten Komponentenliste kann damit das Vorhandensein von Komponenten in der dritten oder vierten Komponentenliste beeinflussen. Die Wahl von Konstruktionskomponenten der dritten Komponentenliste kann damit das Vorhandensein von Komponenten in der vierten Komponentenliste beeinflussen.

In einem Ausführungsbeispiel kann der wenigstens eine Sollwert und/oder Grenzwert mindestens eines Konstruktionsparameters der Oberflächenkonstruktion aus hinterlegten Werten, insbesondere Normen und/oder Richtlinien und/oder Erfahrungswerten, abgerufen und/oder berechnet werden. Damit können die Grenzwerte an hinterlegte Werte automatisch angepasst werden.

Zusätzlich oder alternativ kann der wenigstens eine Sollwert und/oder Grenzwert bedingt durch eingegebene Konstruktionsparameter, insbesondere durch Wahl einer Konstruktionskomponente eingegeben Konstruktionsparameter, abgerufen und/oder berechnet werden. Beispielsweise kann die Wahl einer Vegetation, insbesondere eines Baumes, als Konstruktionskomponente eine Minimalhöhe des Substrats z.B. 60 cm als Grenzwert definieren.

Insbesondere kann ein in einer untergeordneten Komponentenliste eingegebener Konstruktionsparameter mittels eines in einer übergeordneten Komponentenliste durch Wahl einer Konstruktionskomponente definierten wenigstens einen Sollwerts und/oder Grenzwerts überprüft werden. In Bezug auf den vorhergehenden Absatz kann eine Vegetation in einer übergeordneten Liste auswählbar sein und ein Substrat in einer untergeordneten Liste.

In einem bevorzugten Ausführungsbeispiel ist vorgesehen, dass ein Warnsymbol neben mindestens einer der Komponentenlisten angezeigt wird, wenn eine Diskrepanz zum wenigstens einen Sollwert und/oder einer Über- oder Unterschreitung des wenigstens einen Grenzwerts erfasst wird und die Diskrepanz auf die Wahl oder eine Eigenschaft eines Elements dieser mindestens einen Komponentenliste rückführbar ist.

Ein Bediener kann bei einer Suche nach dem Ursprung einer Diskrepanz und/oder einer Über- oder Unterschreitung somit schnell auf den relevanten Bereich geführt werden und den Fehler begutachten und, wenn gewünscht, durch Eingabe eines anderen Konstruktionsparameters beheben.

Es können basierend auf dem wenigstens einen Sollwert oder Grenzwert Konstruktionskomponenten auswählbar sein oder nicht. Konstruktionskomponenten, die einem Sollwert oder Grenzwert nicht entsprechen können damit ausgefiltert werden. Wenn der Grenzwert aus einer Norm bestimmt wird, können Konstruktionskomponenten, welche dieser Norm nicht entsprechen, herausgefiltert werden.

Bei der Berechnung des Datensatzes der Oberflächenkonstruktion auf Basis des mindestens einen Bauwerksparameters und/oder des mindestens einen Konstruktionsparameters können beispielsweise die folgend angegebenen Berechnungen erfolgen.

Es kann vorgesehen sein, dass ein Gewicht pro Flächeneinheit und/oder für den zumindest einen Bereich der Oberflächenkonstruktion dem Gewicht der einzelnen Konstruktionskomponenten berechnet wird. Bevorzugt wird die maximalen Wasserkapazität der einzelnen Konstruktionskomponenten, insbesondere eines verdichteten Substrats, sofern ein solches vorhanden ist, berücksichtigt. Bevorzugt wird auch eine permanente Anstauhöhe, insbesondere in einer durch Retentionselemente gebildete Retentionsebene, berücksichtigt, sofern ein solcher vorhanden ist. Eine temporäre Anstauhöhe muss nicht unbedingt berücksichtigt werden. Die Berechnung erfolgt vorzugsweise durch eine Addition.

Bei der Berechnung des Gewichts kann beispielsweise flächige Vegetation berücksichtigt werden. Stauden, Sträucher und Bäume müssen nicht unbedingt berücksichtigt werden. Es können also gewisse Konstruktionskomponenten berücksichtigt werden und andere nicht.

Es kann vorgesehen sein, eine Aufbauhöhe des Systems aus der Aufbauhöhe der einzelnen Konstruktionskomponenten, insbesondere einem verdichteten Substrat, zu berechnen.

Es kann vorgesehen sein, ein Volumen eines gesamten Wasserspeichers aus der maximalen Wasserkapazität der einzelnen Konstruktionskomponenten, insbesondere der maximalen Wasserkapazität eines verdichteten Substrats, und/oder einer permanenten Anstauhöhe, insbesondere in einer durch Retentionselemente gebildeten Retentionsebene, berechnet wird. Eine temporäre Anstauhöhe muss nicht unbedingt berücksichtigt werden.

Es kann vorgesehen sein, dass ein permanenter Retentionsspeicher aus einer eingegebenen permanenten Anstauhöhe und einer Fläche berechnet wird. Insbesondere wird die Anstauhöhe mit der Fläche multipliziert. Die permanente Anstauhöhe kann innerhalb von Grenzen eingegeben werden, welche von der Höhe einer Konstruktionskomponenten, insbesondere eines Anstauelements, definiert werden.

Es kann vorgesehen sein, dass ein temporärer Retentionsspeicher aus einer eingegebenen temporären Anstauhöhe und einer Fläche berechnet wird. Insbesondere wird die Anstauhöhe mit der Fläche multipliziert. Die temporäre Anstauhöhe kann innerhalb von Grenzen eingegeben werden, welche von der Höhe einer Konstruktionskomponenten, insbesondere eines Anstauelements, definiert werden.

Es kann vorgesehen sein, dass ein Spitzenabflussbeiwert und/oder eine Wasserrückhalt aus hinterlegten Werten, insbesondere Normen und/oder Richtlinien und/oder Erfahrungswerte, abgerufen oder berechnet wird.

Auch kann vorgesehen sein, dass für geprüfte Kombinationen aus Konstruktionskomponenten ein Spitzenabflussbeiwert und/oder ein Wasserrückhalt hinterlegt ist und abgerufen wird, insbesondere wenn die geprüfte Kombination ausgewählt wird oder wenn eine Kombination ausgewählt wird, bei welcher aufgrund deren Konstruktionsparameter geschlossen werden kann, dass der Spitzenabflussbeiwert kleiner oder der Wasserrückhalt größer als bei der geprüften Kombination ist.

Beispielsweise kann, wenn Substrat mit einer geringeren Substrathöhe geprüft wurde und ein Spitzenabflussbeiwert und/oder einer Wasserrückhalt für dieses geprüfte Substrat und diese Substrathöhe hinterlegt ist, auch für ein Substrat mit größerer Substrathöhe die hinterlegten Werte verwendet werden. Die größere Substrathöhe bedingt sicher einen niedrigeren Spitzenabflussbeiwert und einen größeren Wasserrückhalt.

In einem bevorzugten Ausführungsbeispiel kann die Berechnung eines Datensatzes der Oberflächenkonstruktion auf Basis des mindestens einen Bauwerksparameters und/oder des mindestens einen Konstruktionsparameters nach einer weiteren Eingabe mindestens eines Konstruktionsparameters wiederholt werden, insbesondere nach jeder Eingabe mindestens eines Konstruktionsparameters erfolgen.

Damit ist nach jeder Änderung ein aktueller Datensatz vorhanden. Dieser aktuelle Datensatz kann angezeigt werden, sodass eine permanente Überwachung der Daten erfolgen kann.

Es kann optional vorgesehen sein, dass nach jeder Berechnung ein Vergleich wenigstens eines Sollwerts und/oder Grenzwerts mit einem neu berechneten Wert des Datensatzes der Oberflächenkonstruktion erfolgt. Die Überprüfung ist damit immer auf dem aktuellen Stand.

Ein erfindungsgemäßes Verfahren zur Herstellung einer Oberflächenkonstruktion, insbesondere einer bepflanzten Oberflächenkonstruktion, sieht vor, dass ein Entwurf der Oberflächenkonstruktion mittels eines beschriebenen computerimplementierten Verfahrens erstellt wird und die Oberflächenkonstruktion auf Basis des Entwurfs auf zumindest einem Bereich eines Bauwerks, insbesondere eine Dachs, aufgebaut wird oder hergestellt wird.

Dadurch, dass ein Datensatz der Oberflächenkonstruktion auf Basis des mindestens einen Bauwerksparameters und/oder des mindestens einen Konstruktionsparameters berechnet wird, kann die Oberflächenkonstruktion manuell oder automatisch überprüft werden, bevor die Oberflächenkonstruktion gebaut oder hergestellt wird. Eine auf Basis eines so erstellten Entwurfs hergestellte Oberflächenkonstruktion ist überprüft, einfach zu planen und kompatibel mit dem Bauwerk.

Mit "Herstellung" kann der Bau der Oberflächenkonstruktion auf dem Bauwerk und/oder eine Vorherstellung in einem Werk gemeint sein.

In einem bevorzugten Ausführungsbeispiel kann vorgesehen sein, dass die Oberflächenkonstruktion mindestens eine der folgend angegeben Schichten umfasst:
- eine erste Schicht umfassend eine Vegetation und/oder einen Geh- und/oder Fahrbelag,
- eine zweite Schicht umfassend ein Substrat und/oder eine Kiesschicht und/oder eine Tragschicht zur Lastenverteilung,
- eine dritte Schicht mit einem Schutzelement und/oder einem Drainage- und/oder Drainage-Wasserspeicher- und/oder Retentionselement und/oder einer Filterschicht.

Zudem kann die Oberflächenkonstruktion vorzugsweise Zubehörkomponenten, insbesondere mindestens eine Pumpe und/oder mindestens ein Anstauelements und/oder mindestens ein Pumpenschacht und/oder mindestens eine Bewässerungsvorrichtung und/oder mindestens eine Drossel, umfassen und/oder Einfassungen und/oder Pflanzengefäße und/oder Solarunterkonstruktionen und/oder Schrägdachprodukte und/oder Belagunterkonstruktionen.

Weitere Details und Ausführungsbeispiele werden in den Figuren dargestellt. Dabei zeigen:
- Fig. 1: Schnittdarstellung einer Oberflächenkonstruktion mit Vegetation und Retentionselement
- Fig. 2: Schnittdarstellung einer Oberflächenkonstruktion mit Vegetation, Retentionselement, Pumpe und Bewässerungsvorrichtung
- Fig. 3: Schnittdarstellung einer Oberflächenkonstruktion mit Geh- und/oder Fahrbelag und Retentionselement
- Fig. 4: Schnittdarstellung einer Oberflächenkonstruktion mit Kiesfläche und Retentionselement
- Fig. 5: Schnittdarstellung einer Oberflächenkonstruktion mit Kiesfläche und Drainageelement
- Fig. 6: Draufsicht auf mehrere Bereiche eines Bauwerks mit unterschiedlichen Oberflächenkonstruktionen
- Fig. 7: Datenflussdiagramm des computerimplementierten Verfahrens zum Entwerfen einer Oberflächenkonstruktion
- Fig. 8: Datenflussdiagramm des computerimplementierten Verfahrens zum Entwerfen einer Oberflächenkonstruktion mit Überprüfung
- Fig. 9a: Eingabe der Konstruktionsparameter mittels der Auswahl einer Konstruktionskomponente aus einer Komponentenliste, erste Komponentenliste
- Fig. 9b: Eingabe der Konstruktionsparameter mittels der Auswahl einer Konstruktionskomponente aus einer Komponentenliste, zweite Komponentenliste
- Fig. 9c: Eingabe der Konstruktionsparameter mittels der Auswahl einer Konstruktionskomponente aus einer Komponentenliste, dritte Komponentenliste
- Fig. 9d: Eingabe der Konstruktionsparameter mittels der Auswahl einer Konstruktionskomponente aus einer Komponentenliste, vierte Komponentenliste

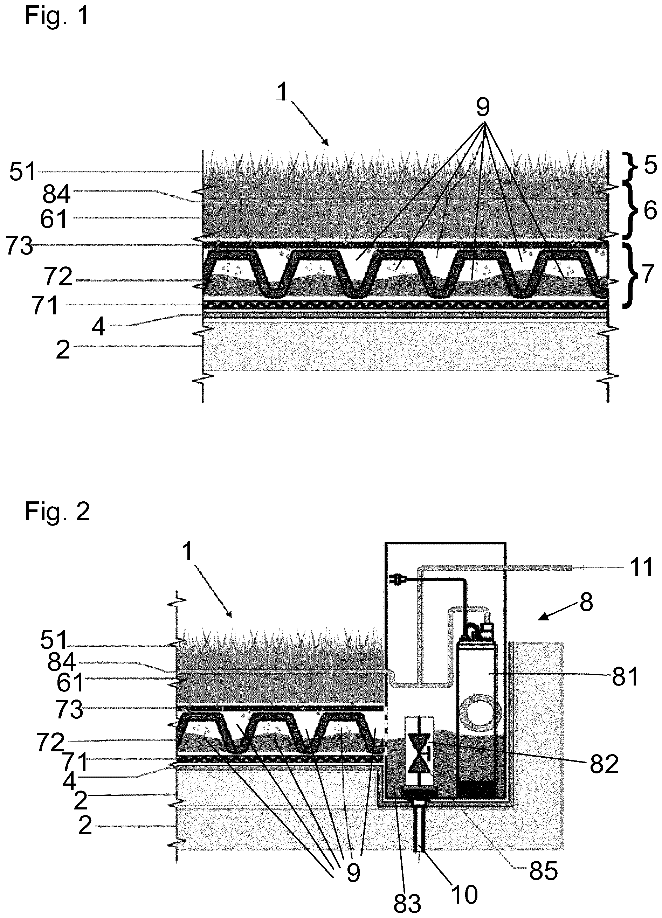

Fig. 1 zeigt eine Schnittdarstellung einer Oberflächenkonstruktion 1 auf einem Bauwerk 2. Vom Bauwerk 2 ist eine ebene Fläche ohne Neigung ersichtlich. Es kann auch vorgesehen sein, dass das Bauwerk zumindest leicht geneigt ist, vorzugsweise weniger als 5°.

Die Oberflächenkonstruktion 1 weist eine erste Schicht 5, eine zweite Schicht 6 und eine dritte Schicht 7 auf.

Die erste Schicht 5 ist die oberste Schicht, welche von außen ersichtlich und vorzugsweise betretbar ist. Sie ist in der Fig. 1 als Vegetation 51 ausgeführt.

Die Vegetation 51 wächst aus einem Substrat 61, wobei im Substrat 61 in dem Ausführungsbeispiel in Fig. 1 eine als Unterflurbewässerung ausgebildete Bewässerungsvorrichtung 84 angeordnet ist. Das Substrat 61 bildet die zweite Schicht 6.

In der dritten Schicht 7 ist eine Filterschicht 73, vorzugsweise in Form eines Filtervlieses, angeordnet. Die Filterschicht 73 verhindert, dass Substrat 61 oder Kies in den Wasserspeicher 9 gelangt, während Wasser zumindest tropfenweise durchgelassen wird.

Unter der Filterschicht 73 ist ein Retentionselement 72 angeordnet, welches die Filterschicht 73 und das Substrat vom Bauwerk 2 beabstandet. Der durch das Retentionselement 72 gebildete Hohlraum formt einen Retentionsspeicher 9 aus. Im Retentionsspeicher 9 kann Wasser, das als Niederschlag oder anderweitig auf die Vegetation auftrifft, temporär oder permanent gespeichert werden.

Das Retentionselement 72 liegt auf einem Schutzelement 71, vorzugsweise einem Schutzvlies, auf. Das Schutzelement 71 schützt die darunter liegende undurchlässige Schicht 4, beispielsweise eine Dachabdichtung, vor Druck des Retentionselements 72 und Wurzeln der Vegetation 51.

In der Fig. 2 weist die Oberflächenkonstruktion 1 der Fig. 1 zudem Zubehörkomponenten 8 auf. Zu den Zubehörkomponenten 8 gehört eine Bewässerungsvorrichtung 84, eine Pumpe 81, ein Anstauelement 82, eine Drossel 85 und einen Pumpenschacht 83.

Wasser aus dem Retentionsspeicher 9 kann in einen Pumpenschacht 83 fließen. Mittels eines Anstauelements 82 kann das Wasser bis zu einer gewünschten Höhe angestaut werden. Das Anstauelement 82 definiert eine permanente Anstauhöhe und damit, zusammen mit der Fläche, das Volumen eines permanenten Retentionsspeichers 9.

Das Anstauelement 82 weist eine Drossel 85, insbesondere mit Bohrungen, auf. Steigt der Wasserspiegel über die permanente Anstauhöhe, kann Wasser, insbesondere durch Bohrungen, mit reduzierter Geschwindigkeit über den Wasserablauf 10 abgeführt werden, um beispielsweise eine mit dem Wasserablauf 10 verbundene Kanalisation zu entlasten. Temporär kann die Anstauhöhe also höher als die permanente Anstauhöhe liegen.

Eine Pumpe 81 kann Wasser über eine Bewässerungsvorrichtung 84 der Vegetation 51 zuführen. Damit wird das Wasser, insbesondere aus dem permanenten Retentionsspeicher 9, recyclet. Sollte das Wasser im Retentionsspeicher 9 zur Neige gehen, kann Wasser mittels einer Frischwasserzufuhr 11 zugeführt werden. Die Bewässerungsvorrichtung 84 ist als Unterflurbewässerung ausgebildet und im Substrat 61 angeordnet.

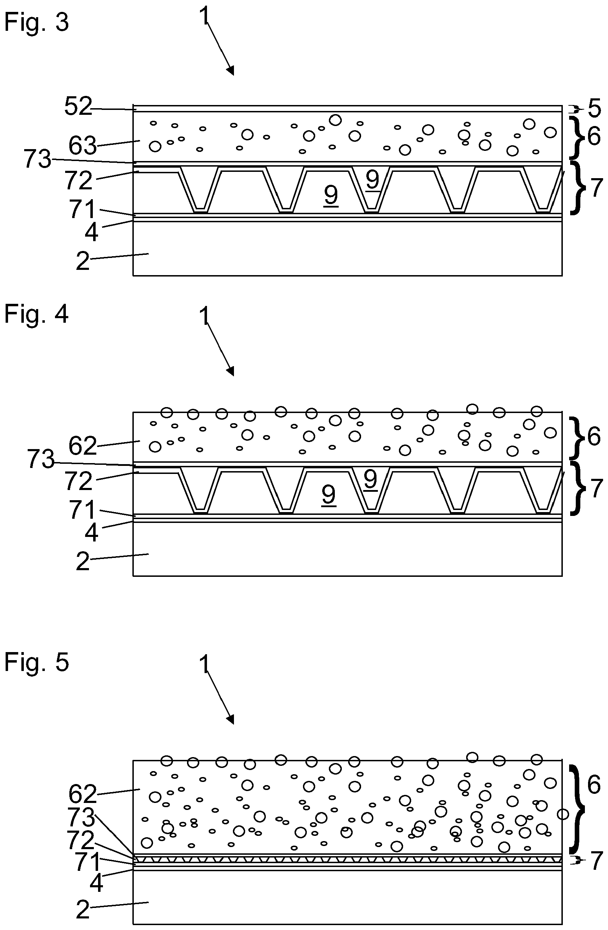

Die Oberflächenkonstruktion 1 aus der Fig. 3 weist anstatt einer Vegetation einen Geh- oder Fahrbelag 52 als erste Schicht 5 auf. Die zweite Schicht 6 ist als Tragschicht 63 für den Geh- oder Fahrbelag 52 ausgebildet. Sie kann beispielsweise aus Schotter oder einem anderen Schüttgut gebildet sein. Auch kann die Tragschicht 63 eine gebundene Tragschicht sein, beispielsweise Beton oder Estrich. Die dritte Schicht 7 ist wie in den Figuren 1 oder 2 ausgebildet.

Die Fig. 4 zeigt eine Oberflächenkonstruktion 1, bei welcher die erste Schicht 5 fehlt. Die oberste Schicht ist damit die zweite Schicht 6, welche als Kiesschicht 62 ausgebildet ist. So kann beispielsweise ein Kiesdach realisiert werden. Die dritte Schicht 7 ist wie in den Figuren 1 bis 3 ausgebildet.

Die Zubehörkomponenten 8 aus Fig. 2 kann auch mit den Ausführungsbeispielen aus den Figuren 3 oder 4 kombiniert werden.

Die Fig. 5 zeigt eine Oberflächenkonstruktion 1, bei welcher die oberste Schicht, wie in Fig. 4, die zweite Schicht 6 ist, welche als Kiesschicht 62 ausgebildet ist.

Die dritte Schicht 7 weist anstatt eines Retentionselements ein Drainageelement 72 auf, welche zwischen einer Filterschicht 73 und einer Schutzschicht 71 angeordnet ist. Das Drainageelement 72 kann beispielsweise als Kunststoffmatte mit Mulden ausgebildet sein, wobei in den Mulden etwas Wasser gehalten werden kann (Drainage-Wasserspeicherelement) . Zudem kann das Drainageelement 72 Wasser abführen. Ein Retentionsspeicher 9 ist nicht vorhanden.

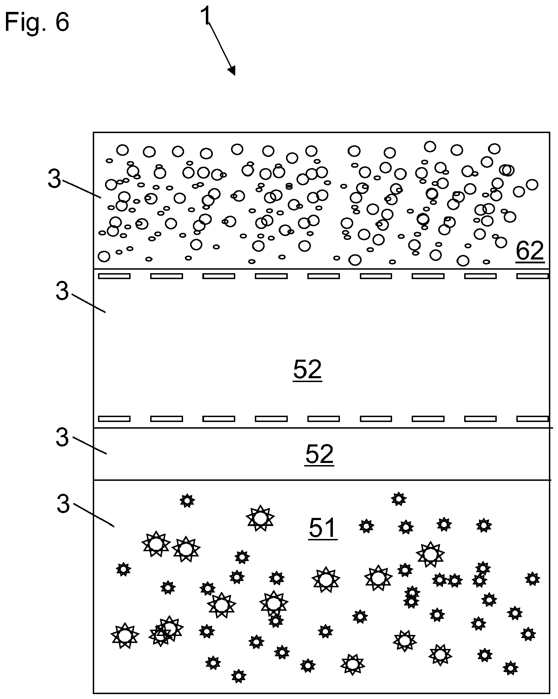

Die Fig. 6 zeigt eine Draufsicht auf mehrere Bereiche 3 eines Bauwerks 2 mit unterschiedlichen Oberflächenkonstruktionen 1. Ein Bereich 3 weist eine Kiesschicht 62 als oberste Schicht auf. Ein weiterer Bereich 3 weist einen Fahrbelag 52 als oberste Schicht auf. Ein weiterer Bereich 3 weist einen Gehbelag 52 als oberste Schicht auf. Ein weiterer Bereich 3 weist eine Vegetationsschicht 51 als oberste Schicht auf.

Fig. 6 illustriert, wie verschiedene Bereiche 3 eines einzigen Bauwerks 2, insbesondere eines Dachs eines Bauwerks 2, mit verschiedenen Oberflächenkonstruktionen 1 versehen werden können. Alle Bereiche 3 können einen gemeinsamen Retentionsspeicher 9 aufweisen.

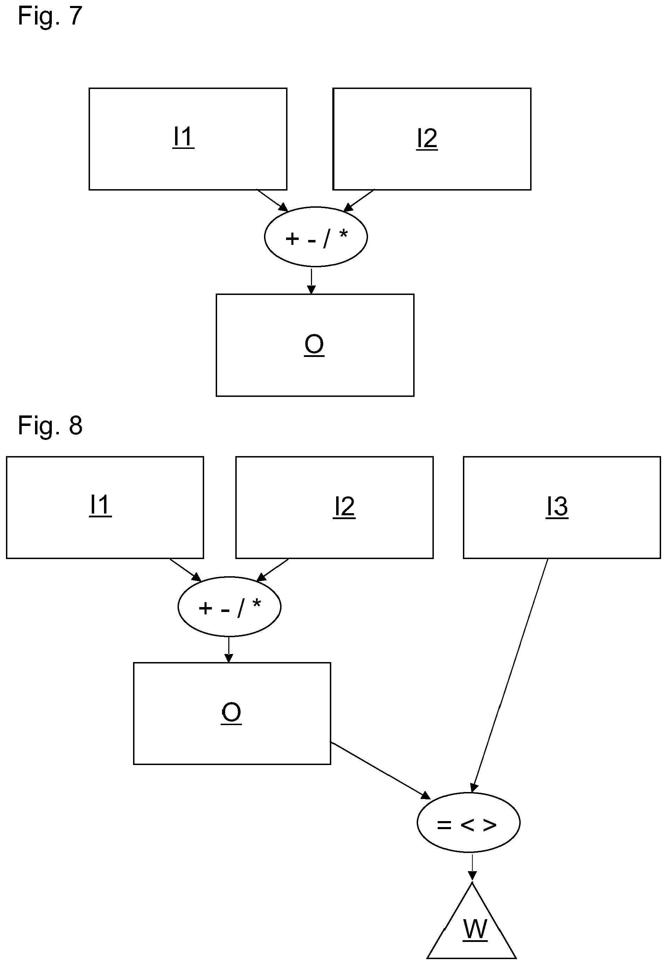

Fig. 7 zeigt ein Datenflussdiagramm des computerimplementierten Verfahrens zum Entwerfen einer Oberflächenkonstruktion 1, insbesondere einer Oberflächenkonstruktion 1 aus den Figuren 1 bis 6.

In Schritt I1 erfolgt eine Eingabe mindestens eines Bauwerksparameters des zumindest eines Bereichs 3 des Bauwerks 2, insbesondere einer Fläche und/oder einer Neigung und/oder eine Angabe zur Art des Bauwerks 2 und/oder eines Orts des Bauwerks 2.

In Schritt I2 erfolgt eine Eingabe mindestens eines Konstruktionsparameters der Oberflächenkonstruktion 1, insbesondere einer Bepflanzung 51 und/oder einer Kiesfläche 62 und/oder eines Geh- und/oder Fahrbelags 52 und/oder einer Substratschicht 61 und/oder einer Tragschicht 63 und/oder von Systemkomponenten, beispielsweise eines Schutzelements 71, eines Drainage-, Drainage-Wasserspeicher- und/oder Retentionselements 72, und/oder von Zubehörkomponenten 8.

Aus den Daten aus den Schritten I1 und I2 erfolgt eine Berechnung eines Datensatzes O der Oberflächenkonstruktion 1 auf Basis des mindestens einen Bauwerksparameters und/oder des mindestens einen Konstruktionsparameters, insbesondere wobei der Datensatz ein Gewicht pro Flächeneinheit und/oder für den zumindest einen Bereich 3, eine Aufbauhöhe, ein Volumen und/oder eine Anstauhöhe eines temporären und/oder permanenten Retentionsspeichers 9, eine Abflussspende und/oder einen Spitzenablussbeiwert umfasst.

Fig. 8 zeigt ein Datenflussdiagramm des computerimplementierten Verfahrens zum Entwerfen einer Oberflächenkonstruktion 1 mit Überprüfung. Zusätzlich zu den zu Fig. 7 beschriebenen Schritten erfolgt in Schritt I3 eine Eingabe und/oder Abruf und/oder Berechnung wenigstens eines Sollwerts und/oder eines Grenzwerts eines Konstruktionsparameters der Oberflächenkonstruktion 1. Danach erfolgt ein Vergleich wenigstens eines Sollwerts und/oder Grenzwerts mit einem berechneten Wert des Datensatzes O der Oberflächenkonstruktion 1, sowie einer Ausgabe einer Warnmeldung W bei der Feststellung einer Diskrepanz zum Sollwert und/oder einer Über- oder Unterschreitung des Grenzwerts.

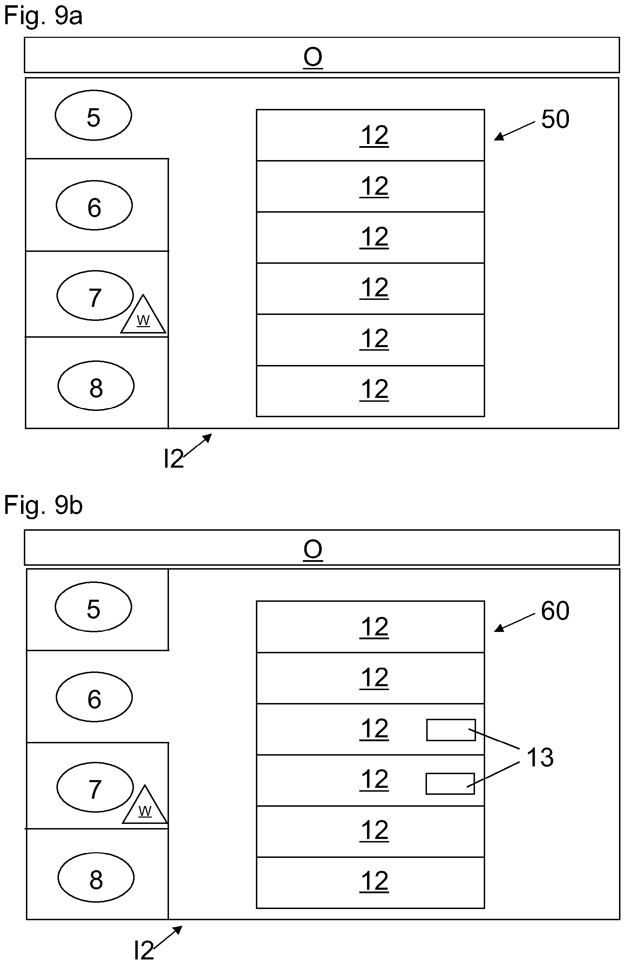

Figuren 9a bis 9d illustrieren die Eingabe I2 der Konstruktionsparameter mittels der Auswahl einer Konstruktionskomponente 12 aus einer Komponentenliste 50, 60, 70, 80.

In Fig. 9a ist in der linken Auswahlspalte die erste Schicht 5 ausgewählt. Im Feld rechts wird daher die erste Komponentenliste 50 mit mehreren Konstruktionskomponenten 12 angezeigt. Die Konstruktionskomponenten 12 der ersten Liste 50 können beispielsweise ein Typ einer Vegetation 51 oder ein Typ eines Geh- oder Fahrbelags 52 sein. Mittels der Auswahl einer Konstruktionskomponenten 12 werden vordefinierte Konstruktionsparameter eingegeben (Schritt I2) .

Nachdem ein Bediener mindestens eine Konstruktionskomponente 12 ausgewählt hat, wird der Datensatz O der Oberflächenkonstruktion 1 aktualisiert und vorzugsweise angezeigt.

Zudem kann ein Vergleich wenigstens eines Sollwerts und/oder Grenzwerts mit einem berechneten Wert des Datensatzes O der Oberflächenkonstruktion 1 erfolgen. In der linken Spalte ist eine Warnmeldung W in der dritten Schicht 7 ersichtlich. Dies gibt einem Bediener einen Hinweis darauf, dass eine Diskrepanz zu einem Sollwert und/oder eine Über- oder Unterschreitung eines Grenzwerts in der dritten Schicht 7 detektiert wurde.

Eine Warnmeldung W kann auch direkt bei der Anzeige des jeweiligen Werts des Datensatzes O angezeigt werden (im Bild oben).

Die in Fig. 9a gezeigte Darstellung muss beispielsweise bei einem Kiesdach ohne Auflage und erste Schicht 5 nicht vorhanden sein.

In der Fig. 9b ist in der linken Auswahlspalte die zweite Schicht 6 ausgewählt, sodass rechts die zweite Komponentenliste 60 angezeigt wird. Die Konstruktionskomponenten 12 der zweiten Komponentenliste 60 sind beispielsweise Typen eines Substrats 61, Typen einer Kiesschicht 62 und/oder Typen einer Tragschicht 63. Insbesondere in der zweiten Schicht 6 kann eine manuelle Eingabe eines Zahlenwerts in einem Eingabefeld 13 vorgesehen sein, insbesondere der Höhe oder einer Anzahl. Schuttgut kann mit variabler Höhe aufgebracht werden.

Die Möglichkeit einer Eingabe eines Konstruktionsparameters in einem Eingabefeld 13 kann auch in anderen Schichten vorgesehen sein und ist hier exemplarisch in der zweiten Schicht 6 gezeigt.

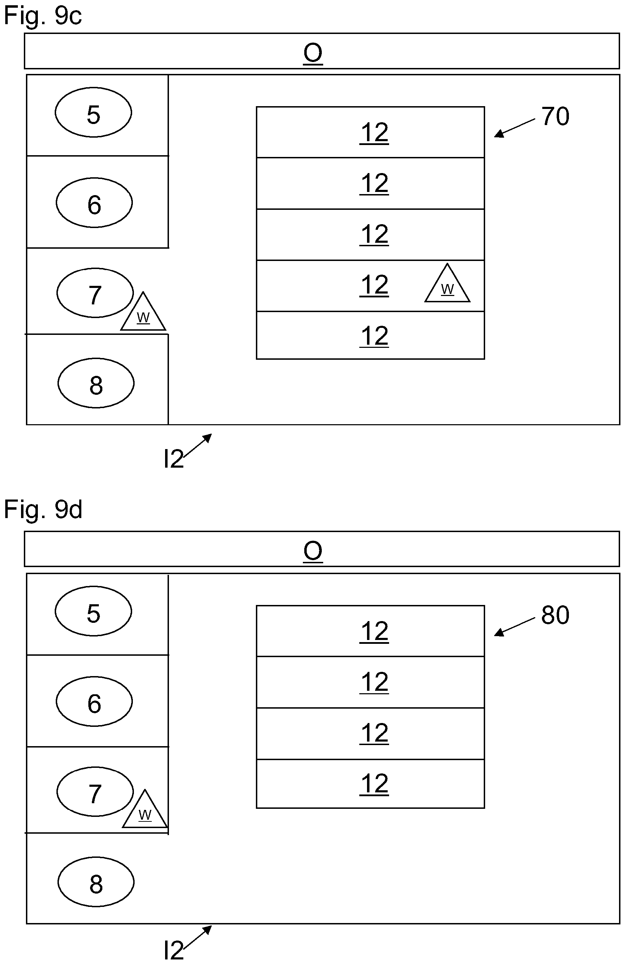

In der Fig. 9c ist in der linken Auswahlspalte die dritte Schicht 7 ausgewählt, sodass rechts die dritte Komponentenliste 70 angezeigt wird. Die Konstruktionskomponenten 12 der dritten Komponentenliste 70 sind beispielsweise Typen eines Schutzelements 71, Typen eines Drainage-, Drainage-Wasserspeicher- und/oder Retentionselements 72 und/oder Typen einer Filterschicht 73.

Bei einer Konstruktionskomponente 12 gibt es in Fig. 9c eine Diskrepanz zum Sollwert und/oder einer Über- oder Unterschreitung des Grenzwerts, was mittels einer Warnmeldung W angezeigt wird. Ein Bediener kann diese Konstruktionskomponente abwählen oder einen Sollwert und/oder Grenzwert anpassen, sodass die Warnmeldung verschwindet.

In der Fig. 9d ist in der linken Auswahlspalte die vierte Schicht 8 ausgewählt, sodass rechts die vierte Komponentenliste 80 angezeigt wird. Die Konstruktionskomponenten 12 der vierten Komponentenliste 80 sind beispielsweise Typen einer Pumpe 81, Typen eines Anstauelements 82, Typen einer Bewässerungsvorrichtung 84, Typen einer Drossel 85 und/oder Typen von Einfassungen, Pflanzengefäßen, Solarunterkonstruktionen, Schrägdachprodukten und/oder Belagunterkonstruktionen.

Das Vorhandensein von Elementen der Komponentenlisten 50, 60, 70, 80 kann von Konstruktionsparameters und/oder Bauwerksparametern und/oder Normen und/oder Richtlinien und/oder Erfahrungswerten abhängen. Auch kann das Vorhandensein von Elementen der Komponentenlisten 50, 60, 70, 80 von einer Wahl einer Konstruktionskomponente 12 in einer übergeordneten Liste abhängen.

### Bezugszeichenliste:

- 1: Oberflächenkonstruktion
- 2: Bauwerk
- 3: Bereich eines Bauwerks
- 4: undurchlässige Schicht / Dachabdichtung
- 5: erste Schicht
- 50: erste Komponentenliste
- 51: Vegetation
- 52: Geh- oder Fahrbelag
- 6: zweite Schicht
- 60: zweite Komponentenliste
- 61: Substrat
- 62: Kiesschicht
- 63: Tragschicht
- 7: dritte Schicht
- 70: dritte Komponentenliste
- 71: Schutzelement
- 72: Drainage-, Drainage-Wasserspeicher- und/oder Retentionselement
- 73: Filterschicht
- 8: Zubehörkomponente
- 80: vierte Komponentenliste
- 81: Pumpe
- 82: Anstauelement
- 83: Pumpenschacht
- 84: Bewässerungsvorrichtung
- 85: Drossel
- 9: Retentionsspeicher
- 10: Wasserablauf
- 11: Frischwasserzufuhr
- 12: Konstruktionskomponente
- 13: Eingabefeld
- I1: Eingabe von Bauwerksparameter
- I2: Eingabe von Konstruktionsparameter
- I3: Eingabe oder Abruf von Sollwerten und/oder Grenzwerten der Konstruktionsparameter
- O: Datensatz der Oberflächenkonstruktion
- W: Warnmeldung

## Patentansprüche

1. Computerimplementiertes Verfahren zum Entwerfen einer Oberflächenkonstruktion (1), insbesondere einer bepflanzten Oberflächenkonstruktion (1), welche auf zumindest einem Bereich (3) eines Bauwerks (2), insbesondere eines Dachs, aufgebaut wird, mit den folgenden Verfahrensschritten:
- Eingabe mindestens eines Bauwerksparameters (I1) des zumindest eines Bereichs (3) des Bauwerks (2), insbesondere einer Fläche und/oder einer Neigung und/oder eine Angabe zur Art des Bauwerks und/oder eines Orts des Bauwerks, und/oder
- Eingabe mindestens eines Konstruktionsparameters (I2) der Oberflächenkonstruktion (1), insbesondere einer Vegetation (51) und/oder einer Kiesfläche (62) und/oder eines Geh- und/oder Fahrbelags (52) und/oder einer Substratschicht (61) und/oder einer Tragschicht (63) und/oder von Systemkomponenten, beispielsweise eines Schutzelements (71), eines Drainage-, Drainage-Wasserspeicher- und/oder Retentionselements (72) und/oder eines Filterelements (73), und/oder von Zubehörkomponenten (8),
- optional Eingabe und/oder Abruf und/oder Berechnung wenigstens eines Sollwerts und/oder eines Grenzwerts (I3) mindestens eines Konstruktionsparameters der Oberflächenkonstruktion (1),
- Berechnung eines Datensatzes (O) der Oberflächenkonstruktion (1) auf Basis des mindestens einen Bauwerksparameters und/oder des mindestens einen Konstruktionsparameters, insbesondere wobei der Datensatz (O) ein Gewicht pro Flächeneinheit und/oder bezogen auf den zumindest einen Bereich (3), eine Aufbauhöhe, ein Volumen und/oder eine Anstauhöhe eines temporären und/oder permanenten Retentionsspeichers (9), eine Abflussspende und/oder einen Spitzenablussbeiwert umfasst,
- optional Vergleich wenigstens eines Sollwerts und/oder Grenzwerts mit einem berechneten Wert des Datensatzes (O) der Oberflächenkonstruktion (1), vorzugsweise Ausgabe einer Warnmeldung (W) bei der Feststellung einer Diskrepanz zum wenigstens einen Sollwert und/oder einer Über- oder Unterschreitung des wenigstens einen Grenzwerts.

2. Computerimplementiertes Verfahren nach dem vorhergehenden Anspruch, wobei die Eingabe des mindestens einen Konstruktionsparameters (I2) zumindest teilweise mittels der Auswahl mindestens einer Konstruktionskomponente (12) mit mindestens einem vordefinierten Konstruktionsparameter aus mindestens einer Komponentenliste (50, 60, 70, 80) erfolgt, vorzugsweise wobei mindestens zwei verschiedene Komponentenlisten (50, 60, 70, 80) vorgesehen sind, besonders bevorzugt wobei
- eine erste Komponentenliste (50) Einträge zu Konstruktionskomponenten (12) einer ersten Schicht (5) der Oberflächenkonstruktion (1), insbesondere Einträge zu einem Vegetationstyp (51) und/oder zu einem Geh- und/oder Fahrbelagstyp (52), und/oder
- eine zweite Komponentenliste (60) Einträge zu Konstruktionskomponenten (12) einer zweiten Schicht (6) der Oberflächenkonstruktion (1), insbesondere Einträge zu einem Substrattyp (61) und/oder zu einem Kiesschichttyp (62) und/oder zu einem Tragschichttyp (63) zur Lastenverteilung, und/oder
- eine dritte Komponentenliste (70) Einträge zu Konstruktionskomponenten (12) einer dritten Schicht (7) der Oberflächenkonstruktion (1), insbesondere Einträge zu einem Schutzelementtyp (71) und/oder zu einem Drainage- und/oder Drainage-Wasserspeicher- und/oder Retentionselementtyp (72) und/oder zu einem Filterschichttyp (73), und/oder
- eine vierte Komponentenliste (80) Einträge zu Zubehörkomponenten (8), insbesondere einer Pumpe (81) und/oder eines Anstauelements (82) und/oder eines Pumpenschachts (83) und/oder einer Bewässerungsvorrichtung (84) und/oder eine Drossel (85) und/oder Einfassungen und/oder Pflanzengefäßen und/oder Solarunterkonstruktionen und/oder Schrägdachprodukten und/oder Belagunterkonstruktionen
enthält.

3. Computerimplementiertes Verfahren nach dem vorhergehenden Anspruch, wobei die Wahl mindestens eines Bauwerksparameters und/oder Konstruktionsparameters und/oder einer Norm und/oder einer Richtlinie und/oder Erfahrungswerten das Vorhandensein von Elementen mindestens einer Komponentenliste (50, 60, 70, 80) beeinflusst, insbesondere bestimmt.

4. Computerimplementiertes Verfahren nach Anspruch 2 oder 3, wobei mindestens zwei Komponentenlisten (50, 60, 70, 80) in mindestens zwei verschiedenen hierarchischen Ebenen organisiert sind und/oder angezeigt werden, wobei die Auswahl einer Konstruktionskomponente aus einer übergeordneten Komponentenliste (50, 60, 70, 80) das Vorhandensein von Elementen mindestens einer untergeordneten Komponentenliste (50, 60, 70, 80) beeinflusst, insbesondere bestimmt, vorzugweise wobei folgende hierarchische Reihenfolge von übergeordnet zu untergeordnet vorgesehen ist:
- erste Komponentenliste (50) mit Einträgen zu Konstruktionskomponenten (12) einer ersten Schicht (5) der Oberflächenkonstruktion (1), insbesondere Einträgen zu einem Vegetationstyp (51) und/oder zu einem Geh- und/oder Fahrbelagstyp (52), sofern die erste Komponentenliste (50) vorhanden ist,
- zweite Komponentenliste (60) mit Einträgen zu Konstruktionskomponenten (12) einer zweiten Schicht (6) der Oberflächenkonstruktion (1), insbesondere Einträgen zu einem Substrattyp (61) und/oder zu einem Kiesschichttyp (62) und/oder zu einem Tragschichttyp (63) zur Lastenverteilung,
- dritte Komponentenliste (70) mit Einträgen zu Konstruktionskomponenten (12) einer dritten Schicht (7) der Oberflächenkonstruktion (1), insbesondere Einträgen zu einem Schutzelementtyp (71) und/oder zu einem Drainage- und/oder Drainage-Wasserspeicher- und/oder Retentionselementtyp (72) und/oder zu einem Filterschichttyp (73),
- vierte Komponentenliste (80) mit Einträgen zu Zubehörkomponenten (8), insbesondere einer Pumpe (81) und/oder eines Anstauelements (82) und/oder eines Kontrollschachts (83) und/oder einer Bewässerungsvorrichtung (84) und/oder einer Drossel (85) und/oder Einfassungen und/oder Pflanzengefäßen und/oder Solarunterkonstruktionen und/oder Schrägdachprodukten und/oder Belagunterkonstruktionen.

5. Computerimplementiertes Verfahren nach einem der Ansprüche 2 bis 4, wobei
- eine Warnmeldung (W), insbesondere ein Warnsymbol, neben mindestens einer der Komponentenlisten (50, 60, 70, 80) angezeigt wird, wenn eine Diskrepanz zum wenigstens einen Sollwert und/oder einer Über- oder Unterschreitung des wenigstens einen Grenzwerts erfasst wird und die Diskrepanz auf die Wahl oder eine Eigenschaft eines Elements dieser mindestens einen Komponentenliste (50, 60, 70, 80) rückführbar ist, und/oder
- basierend auf dem wenigstens einen Sollwert und/oder Grenzwert Konstruktionskomponenten (12) auswählbar oder vorhanden sind oder nicht.

6. Computerimplementiertes Verfahren nach einem der vorhergehenden Ansprüche, wobei der wenigstens eine Sollwert und/oder Grenzwert (I3) mindestens eines Konstruktionsparameters der Oberflächenkonstruktion (1)
- vom Benutzer eingegeben wird, und/oder
- aus hinterlegten Werten, insbesondere Normen und/oder Richtlinien und/oder Erfahrungswerten, abgerufen und/oder berechnet wird, und/oder
- bedingt durch eingegebene Konstruktionsparameter, insbesondere durch Wahl einer Konstruktionskomponente (12) eingegeben Konstruktionsparameter, abgerufen und/oder berechnet wird.

7. Computerimplementiertes Verfahren nach einem der vorhergehenden Ansprüche, wobei
- ein Gewicht pro Flächeneinheit und/oder für den zumindest einen Bereich (3) der Oberflächenkonstruktion (1) aus dem Gewicht der einzelnen Konstruktionskomponenten (12) berechnet wird, bevorzugt inklusive der maximalen Wasserkapazität der einzelnen Konstruktionskomponenten (12), insbesondere des verdichteten Substrats (61), und/oder inklusive einer permanenten Anstauhöhe, insbesondere in einer durch Retentionselemente (72) gebildeten Retentionsebene, berechnet wird, und/oder
- eine Aufbauhöhe der Oberflächenkonstruktion (1) aus der Aufbauhöhe der einzelnen Konstruktionskomponenten (12), insbesondere einem verdichteten Substrat (61), berechnet wird, und/oder
- ein Volumen eines gesamten Wasserspeichers aus der maximalen Wasserkapazität der einzelnen Konstruktionskomponenten (12), insbesondere der maximalen Wasserkapazität eines verdichteten Substrats (61), und/oder einer permanenten Anstauhöhe, insbesondere in einer durch Retentionselemente (72) gebildeten Retentionsebene, berechnet wird, und/oder
- ein permanenter Retentionsspeicher aus einer eingegebenen permanenten Anstauhöhe und einer Fläche berechnet wird, und/oder
- ein temporärer Retentionsspeicher aus einer eingegebenen temporären Anstauhöhe und einer Fläche berechnet wird, und/oder
- ein Spitzenabflussbeiwert und/oder ein Wasserrückhalt
i. aus hinterlegten Werten, insbesondere Normen und/oder Richtlinien und/oder Erfahrungswerte, abgerufen oder berechnet wird, und/oder
ii. für geprüfte Werte von Konstruktionsparametern und/oder Kombinationen aus Konstruktionskomponenten (12) hinterlegt ist und abgerufen wird, insbesondere wenn die geprüfte Kombination ausgewählt wird oder wenn eine Kombination ausgewählt wird, bei welcher aufgrund deren Konstruktionsparameter geschlossen werden kann, dass der Spitzenabflussbeiwert kleiner oder der Wasserrückhalt größer als bei der geprüften Kombination ist.

8. Computerimplementiertes Verfahren nach einem der vorhergehenden Ansprüche, wobei die Berechnung eines Datensatzes (O) der Oberflächenkonstruktion (1) auf Basis des mindestens einen Bauwerksparameters und/oder des mindestens einen Konstruktionsparameters nach einer weiteren Eingabe mindestens eines Konstruktionsparameters (I2) wiederholt wird, insbesondere nach jeder Eingabe mindestens eines Konstruktionsparameters (I2) erfolgt.

9. Vorrichtung zur Datenverarbeitung, umfassend Mittel zur Ausführung des Verfahrens nach einem der vorhergehenden Ansprüche.

10. Computerlesbares Speichermedium, umfassend Befehle, die bei der Ausführung durch einen Computer diesen veranlassen, das Verfahren nach eine der Ansprüche 1 bis 8 auszuführen.

11. Computerprogrammprodukt, umfassend Befehle, die bei der Ausführung des Programms durch einen Computer diesen veranlassen, das Verfahren nach einem der Ansprüche 1 bis 8 auszuführen.

12. Computerlesbarer Datenträger, auf dem das Computerprogrammprodukt nach dem vorhergehenden Anspruch gespeichert ist.

13. Datenträgersignal, das das Computerprogrammprodukt nach Anspruch 11 überträgt.

14. Verfahren zur Herstellung einer Oberflächenkonstruktion (1), insbesondere einer bepflanzten Oberflächenkonstruktion (1), wobei
- ein Entwurf der Oberflächenkonstruktion (1) mittels eines computerimplementierten Verfahrens nach einem der Ansprüche 1 bis 8 erstellt wird und
- die Oberflächenkonstruktion (1) auf Basis des Entwurfs auf zumindest einem Bereich (3) des Bauwerks (2), insbesondere des Dachs, aufgebaut wird oder hergestellt wird.

15. Verfahren nach dem vorhergehenden Anspruch, wobei die Oberflächenkonstruktion (1) mindestens eine der folgend angegeben Schichten umfasst:
- eine erste Schicht (5) umfassend eine Vegetation (51) und/oder einen Geh- und/oder Fahrbelag (52),
- eine zweite Schicht (6) umfassend ein Substrat (61) und/oder eine Kiesschicht (62) und/oder eine Tragschicht (63) zur Lastenverteilung,
- eine dritte Schicht (7) mit einem Schutzelement (71) und/oder einem Drainage- und/oder Drainage-Wasserspeicher- und/oder Retentionselement (72) und/oder einer Filterschicht (73),
und wobei die Oberflächenkonstruktion (1) vorzugsweise Zubehörkomponenten (8), insbesondere mindestens eine Pumpe (81) und/oder mindestens ein Anstauelements (82) und/oder mindestens einen Pumpenschacht (83) und/oder mindestens eine Bewässerungsvorrichtung (84) und/oder mindestens eine Drossel (85) und/oder Einfassungen und/oder Pflanzengefäße und/oder Solarunterkonstruktionen und/oder Schrägdachprodukte und/oder Belagunterkonstruktionen, umfasst.
